# EUROPEAN PATENT SPECIFICATION

(11) **EP 2 593 585 B1**
(45) Date of publication and mention of the grant of the patent: **30.08.2017**
(21) Application number: 11745503.0
(22) Date of filing: 13.07.2011
(51) Int. Cl.: C25D 1/00, C25D 7/12, C25D 17/06, H01L 21/687

(54) **LEVELING OF MASTER ELECTRODE AND SUBSTRATE IN ECPR, AND A CHUCK THEREFOR**
NIVELLIERUNG VON MASTERELEKTRODE UND SUBSTRAT BEI EINEM ECPR-VERFAHREN SOWIE SPANNFUTTER DAFÜR
NIVELLEMENT D'UNE ÉLECTRODE DE RÉFÉRENCE ET D'UN SUBSTRAT DANS UN PROCESSUS ECPR, ET MANDRIN POUR CE FAIRE

(30) Priority: 16.07.2010 US 364989 P; 15.07.2010 SE 1050799
(43) Date of publication of application: 22.05.2013
(73) Proprietor: Luxembourg Institute of Science and Technology (LIST), 4362 Esch-sur-Alzette (LU)
(72) Inventor: UTTERBÄCK, Tomas, S-762 61 Rimbo (SE); SVENSSON, Stefan, S-182 31 Danderyd (SE); LINDGREN, Lennart, S-125 33 Älvsjö (SE); MÖLLER, Patrik, S-112 32 Stockholm (SE); CHAUVET, Jean-Michel, S-125 43 Älvsjö (SE); SANTOS, Antonio, S-164 45 Kista (SE); CAVAZZA, Gilbert, F-74250 Viuz En Sallaz (FR)
(74) Representative: Lecomte & Partners
(86) International application number: PCT/EP2011/061993
(87) International publication number: WO 2012/007523

(56) References cited:
- WO-A1-02/103085
- JP-A- 59 088 831
- JP-A- 2004 165 523

## Description

### Field of the Invention

This invention pertains in general to the field of electrochemical pattern replication. More particularly the invention relates to a method for leveling a master electrode and a substrate in ECPR, and a chuck adapted therefore.

### Background of the Invention

Electroplating/electroetching is used for microelectronics in a wide range of applications, such as interconnects, components, waveguides, inductors, contact pads etc.

In the field of microelectronics electroplating/electroetching is suitable for applications involving production of micro and nano structures in single or multiple layers, fabrication of PWB (printed wiring boards), PCB (printed circuit boards), MEMS (micro electro mechanical systems), IC (integrated circuit) interconnects, above IC interconnects, sensors, flat panel displays, magnetic and optical storage devices, solar cells and other electronic devices. It can also be used for different types of structures in conductive polymers, structures in semiconductors, structures in metals, and others. Even 3D-structures in silicon, such as by formation of porous silicon, are possible.

Chemical vapour deposition and physical vapour deposition are processes that may also be used for metallization, but electroplating/electroetching is often preferred since it is generally less expensive than other metallization processes and it can take place at ambient temperatures and at ambient pressures.

Electroplating/electroetching of a work piece takes place in a reactor containing an electrolyte. An anode, carrying the metal to be plated, is connected to a positive voltage. In some cases, the anode is inert and the metal to be plated comes from the ions in the electrolyte. The conductivity of the work piece, such as a semiconductor substrate, is generally too low to allow the structures to be plated to be connected through the substrate to backside contacts. Therefore, the structures to be plated first have to be provided with a conductive layer, such as a seed layer. Leads connect the pattern to finger contacts on the front side. The finger contacts are in turn connected to a negative voltage. The electroplating step is an electrolytic process where the metal is transferred from the anode, or from the ions in the electrolyte, to the conductive pattern (cathode) by the electrolyte and the applied electric field between the anode and the conductive layer on the work piece, which forms the cathode.

The ever-increasing demand for smaller, faster and less expensive microelectronic and micro-electromechanical systems requires corresponding development of efficient and suitable manufacturing techniques, which has resulted in the development of electrochemical pattern replication (ECPR).

In ECPR plating/etching cells or cavities are formed between a master electrode and the substrate, said cavities being defined by a conductive surface on the master electrode, an insulating material, defining the pattern to be plated/etched, and the conductive surface of the substrate. During plating, a predeposited anode material has been arranged, normally through electrochemical plating, in the cavities. The master electrode and the substrate are put in close contact with each other in the presence of an electrolyte, suitable for the intended purpose, such that the electrolyte is "trapped" in the ECPR plating/etching cavities. WO 02/103085, to the present inventors, describes a system of this kind.

Patent document published JP 59 088831 A discloses a chuck that is suitable for holding a substrate or master electrode in an ECPR process, said chuck having a proximal and a distal end, said chuck comprising an interaction surface for holding the substrate or master electrode positioned in a first plane; holding means for holding the substrate or master electrode to said interaction surface; teeth arranged laterally and circumferentially of said interaction surface and extending distally, the distal end points of said leveling teeth defining a second plane; wherein said second plane is parallel to the first plane and positioned distally of the first plane.

Due to the close interaction between the master electrode and the substrate during ECPR there is a need for aligning/leveling the master electrode and the substrate before performing the transport of material from one to the other, in order to ensure that the interaction surfaces of the master electrode and the substrate can be brought into substantially full contact. Otherwise, tailing (plating underneath the insulating material on the master electrode) in the case of ECPR plating; or lateral etching of the substrate underneath the insulating material on the master electrode in the case of ECPR etching; becomes a problem in areas where the interaction surfaces of the master electrode and the substrate have been in a too proximal position during printing, creating inferior results.

### Summary of the Invention

Accordingly, the present invention preferably seeks to mitigate, alleviate or eliminate one or more of the above-identified deficiencies in the art and disadvantages singly or in any combination. At least these problems are solved by a chuck for holding a substrate or master electrode in an ECPR process, said chuck having a proximal and a distal end, said chuck comprising an interaction surface for holding the substrate or master electrode positioned in a first plane; holding means for holding the substrate or master electrode to said interaction surface; leveling teeth arranged laterally and circumferentially of said interaction surface and extending distally beyond the interaction surface, the distal end points of said leveling teeth defining a second plane; wherein said second plane is parallel to the first plane and positioned distally of the first plane; and a chuck assembly, comprising a chuck according to above and an opposite chuck, said opposite chuck comprising an interaction surface for holding the substrate or master electrode positioned in a third plane; holding means for holding the substrate or master electrode to said interaction surface; a rigid leveling area laterally and circumferentially of said interaction surface, said leveling area corresponding in lateral position to the lateral position of the leveling teeth, said leveling area and interaction surface being parallel; and a method of leveling a chuck assembly according to above, comprising loosening the chuck according to above, bringing the chuck according to above and the opposite chuck into contact, such that the leveling teeth will sit on the leveling area, locking the chuck according to above, such that the plane of the interaction surface of the chuck according to above is fixated to be parallel to the plane of the interaction surface.

Further advantageous embodiments will be apparent from the appended dependent claims.

### Brief Description of the Drawings

These and other aspects, features and advantages of which the invention is capable of will be apparent and elucidated from the following description of embodiments of the present invention, reference being made to the accompanying drawings, in which
Fig. 1 is a schematic view of an ECPR arrangement;
Fig. 2 is a side view of a chuck according to one embodiment of the present invention;
Fig. 3 is a side view of a chuck according to one embodiment of the present invention, sitting on a lower chuck;
Fig. 4 is a perspective view of a chuck according to one embodiment of the present invention;
Fig. 5 is a cross sectional view of a chuck according to one embodiment of the present invention; and
Fig. 6 is a cross sectional view of a lateral part of a chuck according to one embodiment of the present invention.

### Description of embodiments

The following description focuses on embodiments of the present invention applicable to a method for leveling a master electrode and a substrate during ECPR. However, it will be appreciated that the invention is not limited to this application but may be applied to many other replication, patterning or bonding processes within the field of micro electronics and/or mechanics where leveling of two surfaces is beneficial, including for example wafer bonding, various lithographic processes, dry or wet etching processes, etc.

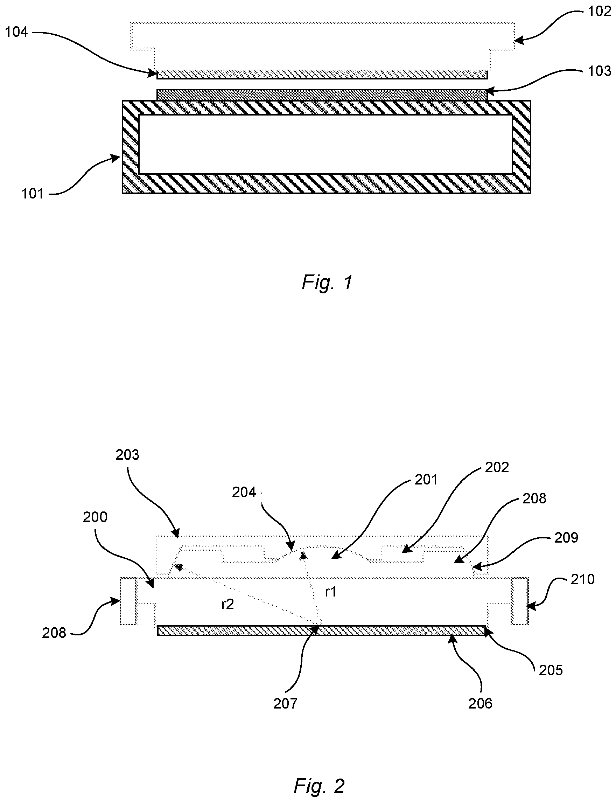

In Fig. 1 a schematic view of an ECPR setting is disclosed. A lower and an upper chuck 101, 102 carry a master electrode 103 and a substrate 104, respectively. The master electrode 103 comprises a conducting disc, at least one insulating layer arranged on the conducting disc, cavities in the insulating layer and/or in the conducting disc, a substantially inert electrode layer arranged in the bottom of said cavities on the conducting disc and may comprise an anode material (such as copper), dissolvable in an electrochemical process, arranged in said cavities on the electrode layer. An electrolyte is provided between the master electrode 103 and the substrate 104, such that electrochemical cells are created between the two, defined by the (patterned) insulating material (not shown), electrode layer (not shown) or prefilled anode material (not shown) on the master electrode 103 and the substrate. Due to the fact that the master electrode 103 and the substrate 104 are to be in close contact, in such a manner that the insulating material of the master electrode 103 closes the electrochemical cells in all positions of the interaction, it is important that the master electrode 103 and the substrate 104, and thus the lower and upper chucks 101, 102, align/level in the horizontal plane in a predictable manner.

Fig. 2 discloses an upper chuck 200 according an embodiment of the present invention. For the sake of convenience, only embodiments relating to the upper chuck will be described below, although the same arrangements are equally possible for the lower chuck. The upper chuck 200 has a proximal end a distal end. The upper chuck 200 is hanging from a semi-sphere-socket bearing. In the proximal end the upper chuck 200 may comprise a semi-spherical head 201. The semi- spherical head 201 is positioned in a cavity 202 in an upper chamber piece 203. The upper chamber piece 203 comprises a central concave semi-spherical surface 204, having a radius corresponding to the radius of the semi-spherical head 201, such that the head 201 may rotate in said concave surface 204 in a ball in joint manner. The head 201 may be spring mounted to the upper chamber piece 203, such that the head 201 is locked in position during a first pressure in the cavity 202. The pre-loading force between the two surfaces, acting to lock them in position, can be further increased by arranging vacuum or reduced pressure in portions of the surfaces between the spherical head 201 and the upper chamber piece 203. When applying a pressure in the cavity 202 being higher than the first pressure, the head 201 is released, and will float against the concave surface 204. In this way the upper chuck 200 and an interaction surface 205, for holding a substrate 206 or a master electrode, will float in three dimensions, having a rotational centre in a centre point 207, the rotational centre being determined by the radius of the semi-spherical surfaces of the semi- spherical head. The substrate 206 or the master electrode may be held to the interaction surface by suitable holding means, such as applied vacuum in a sealed of area between the chuck 200 and the substrate or master electrode, or other mechanical holding means, such as circumferentially arranged clamps etc. The centre point 207 may preferably be positioned in the centre of the interaction surface 205. The interaction surface 205 has a under the circumstances planar configuration. This means that the proximodistal variation when the interaction surface 205 is horizontally aligned is below 3 micrometers. Then the interaction surface 205 will float while keeping this centre point 207 in the same vertical and horizontal position. Laterally of the head 201 a second convex segmental-spherical surface 208 on the upper chuck 200 may interact in the same manner with a concave segmental-spherical surface 209, the segmental-spherical surfaces having a radius r2 such that their point of rotation also will be positioned in the centre point 207. In this way a more steady bearing may be obtained, assuring minimized lateral movement and minimized movement of the centre point of the interaction surface 205.

Other arrangements than floating ball in socket arrangements are equally possible, such as loosening a chuck stem (not shown) from a tightening arrangement in an upper piece allowing for plane alignment, and then tighten the tightening arrangement, once the leveling has been performed. It is however preferable to use the floating ball in socket arrangement according to above, since this allows for quick and reliable leveling, which is of special importance in the quest for improved manufacturing methods of printed wafers, to satisfy the high demand from the society.

Laterally of the interaction surface 205 leveling teeth 210 are arranged. By arranging the leveling teeth 210 laterally of the interaction surface 205, creates a long lever for rotational movement to make sure the parallelism between the two chucks can be established without undue force. Also the margin of error may be decreased. The leveling teeth 210 are evenly distributed circumferentially of the interaction surface 205. The leveling teeth 210 may for example be distributed circumferentially of the interaction surface with 120 degrees apart, calculated from the centre axis. To ensure that the leveling teeth 210 will define a plane between their distal end points, at least three leveling teeth 210 are arranged circumferentially of the interaction surface 205. The leveling teeth 210 extend distally beyond the interaction surface 205 when the interaction surface 205 is in the horizontal plane. The distal end points of the leveling teeth 210 define a plane that is parallel and distally positioned with regard to the plane of the interaction surface 205. The difference in distal position between the plane of the interaction surface 205 and the plane defined by the leveling teeth 210 may be just smaller than the sum of the thickness of the master electrode and the thickness of the substrate. In this way, leveling can be performed without master electrode and substrate in place on the lower and upper chuck pieces, respectively, while subsequently performing printing with leveled chucks without having to remove the leveling teeth.

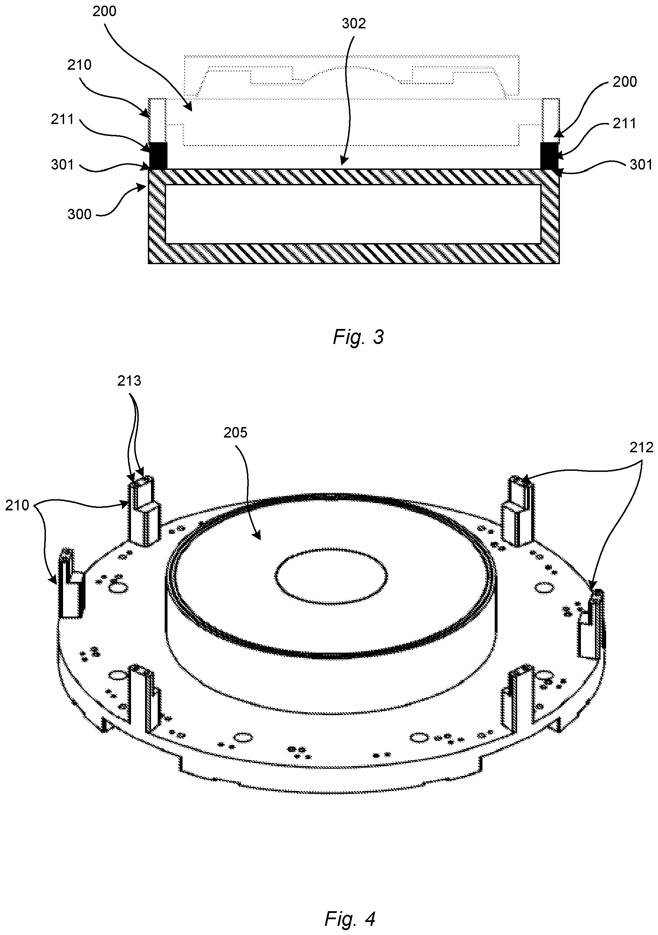

In Fig. 3 it is disclosed how an upper chuck 200 of this kind has been brought into contact with a lower chuck 300, such that the leveling teeth 210 are sitting on a leveling area 301 on the lower chuck 300. The leveling area 301 is positioned circumferentially of an interaction surface 302 for holding a master electrode. The leveling area 301 and the interaction surface 302 are parallel and may be located in the same plane for ease of manufacture, due to facilitated one step polishing step of both the leveling area 301 and the interaction surface 302, and to simplify later electrolyte injection etc. The leveling area 301 has full mechanical support beneath the surface of the leveling area 301, such that the leveling area becomes rigid.

When performing the leveling, the upper chuck 200 is loosened from the upper chamber piece 203, by applying a suitable pressure in the cavity 202, such that the upper chuck starts to float, and the plane of the interaction surface 205 and the leveling teeth 210 becomes adjustable in space. Then the upper chuck 200 is lowered into contact with the lower chuck 300 and the leveling teeth 210 will sit on a leveling area 301, such as disclosed in Fig. 3. When the leveling teeth 210 sits on the leveling area 301 the interaction surface 205 and the interaction surface 302 will be parallel. In this position the upper chuck 200 is locked to the upper chamber piece 203 by releasing the pressure in the cavity 202.

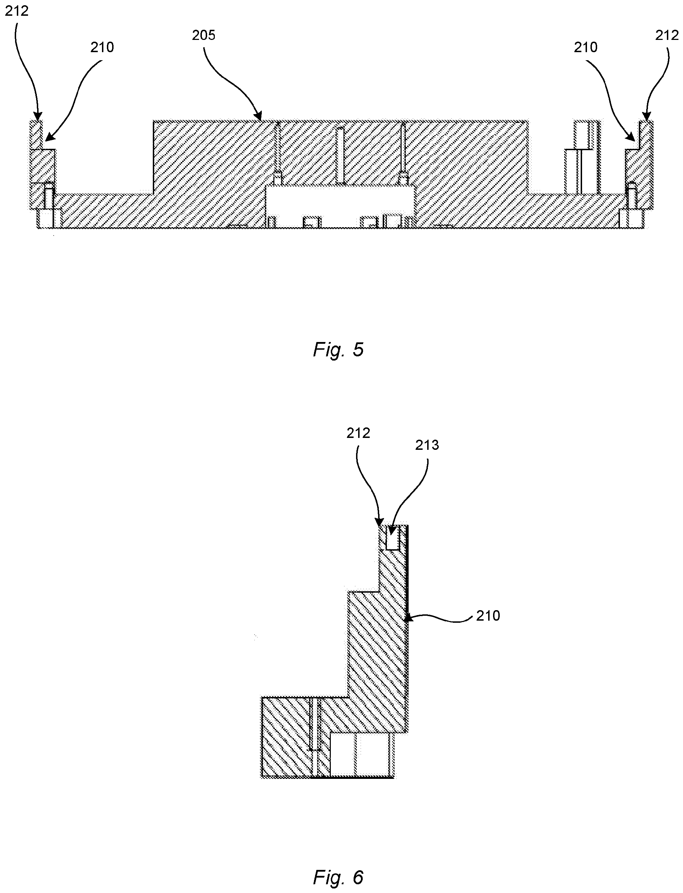

The leveling teeth 210 may comprise distance members 211, as disclosed in Fig. 3. When the leveling teeth 210 comprise distance members 211, leveling teeth base 212 may be manufactured by polishing at the same time as the interaction a surface 205, as disclosed in Figs. 4 to 6. Thereafter holes 213 for receiving the distance members 211 are accurately drilled into the teeth base 212, as disclosed in Figs. 4. and 6. The distance members 211 are then manufactured with the same height, such that they will provide the same distal extension from the teeth base 212. Thus it can be assured that the distal end points of the leveling teeth 210, in this embodiment the distal end points of the distance members 211, define a plane that is parallel with the interaction surface 205. The distance members 211 may be manufactured in a magnetic material. When the distance members 211 are manufactured in a magnetic material, there is no need for adding additional material, such as glue or other adhesive, which would make it difficult to control that the plane defined by the distal end points of the leveling teeth 210 and the plane of the interaction surface 205 are parallel. Also, such distance members may be securely used in upper chucks without falling out of the holes 213 in the teeth base 212.

It is readily understood that all references to lower/upper are merely for illustrative purposes, without any limiting effect on the scope of protection. Moreover, it should be realized that equivalent setups to those described may include setups having a substrate arranged on a lower chuck while the master electrode is mounted on an upper chuck, as well as setups in which the positions of the lower and upper chuck are switched.

## Claims

1. A chuck for holding a substrate or master electrode in an electrochemical pattern replication (ECPR) process, said chuck having a proximal and a distal end, said chuck comprising
an interaction surface (205) for holding the substrate or master electrode positioned in a first plane;
holding means for holding the substrate or master electrode to said interaction surface (205);
leveling teeth (210) arranged laterally and circumferentially of said interaction surface and extending distally beyond the interaction surface (205), the distal end points of said leveling teeth (210) defining a second plane;
wherein said second plane is parallel to the first plane and positioned distally of the first plane.

2. The chuck according to claim 1, wherein the leveling teeth (210) are evenly distributed around the interaction surface (205).

3. The chuck according to claim 1 or 2, wherein the leveling teeth (210) are distributed circumferentially of the interaction surface with 120 degrees apart, calculated from a centre axis of the chuck.

4. The chuck according to any of the preceding claims, wherein the number of leveling teeth (210) is at least three.

5. The chuck according to any of the preceding claims, wherein said leveling teeth (210) comprise teeth bases (212), respectively, said teeth bases (212) being positioned in the first plane, and distance members (211) extending distally from said teeth bases (212), such that the distal end points of the leveling teeth are the distal end points of the distance members (211).

6. The chuck according to claim 5, wherein the distance members (211) are inserted in holes (213) in the teeth bases (212).

7. The chuck according to claim 5 or 6, wherein the distance members are magnetic.

8. The chuck according to any of the preceding claims, wherein the proximal end of the chuck comprises a semi-spherical head (201), said semi-spherical head (201) being positioned in a cavity (202) in a chamber piece (203), said chamber piece (203) comprising a concave semi-spherical surface (204), having a first radius (r1) corresponding to the radius of the semi-spherical head (201), such that the semi-spherical head (201) may rotate in said concave surface (204) in a ball in joint manner, there being provided a gas inlet to said cavity (202).

9. The chuck according to claim 8, wherein the semi- spherical head (201) is spring mounted to the chamber piece (203).

10. The chuck according to claim 9, wherein the semi-spherical head (201) is spring mounted and portions of the surface pre-loaded with vacuum to the chamber piece (203).

11. The chuck according to claim 8 or 10, comprising a second convex segmental-spherical surface (208) interact with a concave segmental-spherical surface (209) on the chamber piece (203), said segmental-spherical surfaces having a second radius (r2).

12. The chuck according to any of claims 8 to 11, wherein the first radius (r1) and the second radius (r2) have the same rotational centre positioned in a centre point (207) on the interaction surface (205).

13. A chuck assembly, comprising a chuck according to any of claims 1 to 12, and an opposite chuck, said opposite chuck comprising an interaction surface (302) for holding the substrate or master electrode positioned in a third plane; holding means for holding the substrate or master electrode to said interaction surface (302); a rigid leveling area (301) laterally and circumferentially of said interaction surface (302), said leveling area (301) corresponding in lateral position to the lateral position of the leveling teeth (210), said leveling area (301) and interaction surface (302) being parallel.

14. A method of leveling a chuck assembly according to claim 13, comprising loosening the chuck according to any of claims 1 to 11,
bringing the chuck according to any of claims 1 to 11 and the opposite chuck into contact, such that the leveling teeth (210) will sit on the leveling area (301),
locking the chuck according to any of claims 1 to 11, such that the plane of the interaction surface (205) of the chuck according to any of claims 1 to 11 is fixated to be parallel to the plane of the interaction surface (302).

## Patentansprüche

1. Haltevorrichtung zum Halten eines Substrats oder einer Masterelektrode in einem Verfahren zur elektrochemischen Musterreplikation (ECPR), wobei die Haltevorrichtung ein proximales und ein distales Ende aufweiset, wobei die Haltevorrichtung umfasst:
eine Interaktionsfläche (205) zum in einer ersten Ebene angeordnet Halten des Substrats oder der Masterelektrode;
Haltemitteln zum Halten des Substrats oder der Masterelektrode an der Interaktionsfläche (205);
Nivellierzähne (210), die lateral und in Umfangsrichtung zu der Interaktionsfläche angeordnet sind und sich distal über die Interaktionsfläche (205) hinaus erstrecken, wobei die distalen Endpunkte der Nivellierzähne (210) eine zweite Ebene definieren;
wobei die zweite Ebene parallel zu der ersten Ebene ist und distal von der ersten Ebene angeordnet ist.

2. Haltevorrichtung nach Anspruch 1, wobei die Nivellierzähne (210) gleichmäßig um die Interaktionsfläche (205) herum verteilt sind.

3. Haltevorrichtung nach Anspruch 1 oder 2, wobei die Nivellierzähne (210) umfangsgerichtet zu der Interaktionsfläche verteilt sind, mit Zwischenabständen von 120 Grad, berechnet ab einer Mittelachse der Haltevorrichtung.

4. Haltevorrichtung nach einem der vorhergehenden Ansprüche, wobei die Anzahl von Nivellierzähnen (210) mindestens drei beträgt.

5. Haltevorrichtung nach einem der vorhergehenden Ansprüche, wobei die Nivellierzähne (210) jeweils Zahnfüße (212), welche Zahnfüße (212) in der ersten Ebene angeordnet sind, und Distanzstücke (211), die sich distal von diesen Zahnfüßen (212) erstrecken, umfassen, sodass die distalen Endpunkte der Nivellierzähne die distalen Endpunkte der Distanzstücke (211) sind.

6. Haltevorrichtung nach Anspruch 5, wobei die Distanzstücke (211) in Öffnungen (213) in den Zahnfüßen (212) eingesetzt werden.

7. Haltevorrichtung nach Anspruch 5 oder 6, wobei die Distanzstücke magnetisch sind.

8. Haltevorrichtung nach einem der vorhergehenden Ansprüche, wobei das proximale Ende der Haltevorrichtung einen halbkugelförmigen Kopf (201) umfasst, wobei der halbkugelförmige Kopf (201) in einem Hohlraum (202) in einem Kammerteil (203) angeordnet ist, wobei das Kammerteil (203) eine konkave halbkugelförmige Oberfläche (204) umfasst, die einen ersten Radius (r1) aufweiset, der dem Radius des halbkugelförmigen Kopfs (201) entspricht, sodass der halbkugelförmige Kopf (201) kugelgelenkartig in der konkaven Oberfläche (204) rotieren kann, wobei ein Gaseinlass zu dem Hohlraum (202) vorgesehen ist.

9. Haltevorrichtung nach Anspruch 8, wobei der halbkugelförmige Kopf (201) federnd an dem Kammerteil (203) befestigt ist.

10. Haltevorrichtung nach Anspruch 9, wobei der halbkugelförmige Kopf (201) federnd befestigt ist und Teile der Oberfläche mittels Vakuum zu dem Kammerteil (203) vorgespannt sind.

11. Haltevorrichtung nach Anspruch 8 oder 10, eine zweite konvexe kugelsegmentförmige Oberfläche (208) umfassend, die mit einer konkaven kugelsegmentförmigen Oberfläche (209) an dem Kammerteil (203) in Wechselwirkung tritt, wobei die kugelsegmentförmigen Oberflächen einen zweiten Radius (r2) aufweise.

12. Haltevorrichtung nach einem der Ansprüche 8 bis 11, wobei der erste Radius (r1) und der zweite Radius (r2) denselben, in einem Mittelpunkt (207) auf der Interaktionsfläche (205) angeordneten Rotationsmittelpunkt aufweise.

13. Haltevorrichtungsanordnung, umfassend eine Haltevorrichtung nach einem der Ansprüche 1 bis 12 und eine gegenüberliegende Haltevorrichtung, wobei die gegenüberliegende Haltevorrichtung umfasst: eine Interaktionsfläche (302) zum in einer dritten Ebene angeordnet Halten des Substrats oder der Masterelektrode; Haltemittel zum Halten des Substrats oder der Masterelektrode an die Interaktionsfläche (302); einen starren Nivellierbereich (301) seitlich und in Umfangsrichtung von der Interaktionsfläche (302), wobei der Nivellierbereich (301) in lateraler Position der lateralen Position der Nivellierzähne (210) entspricht, wobei der Nivellierbereich (301) und die Interaktionsfläche (302) parallel sind.

14. Verfahren zur Nivellierung einer Haltevorrichtungsanordnung nach Anspruch 13, umfassend das Lösen der Haltevorrichtung nach einem der Ansprüche 1 bis 11,
Inkontaktbringen der Haltevorrichtung nach einem der Ansprüche 1 bis 11 mit der gegenüberliegenden Haltevorrichtung, sodass die Nivellierzähne (210) auf dem Nivellierbereich (301) aufsitzen, Blockieren der Haltevorrichtung nach einem der Ansprüche 1 bis 11, sodass die Ebene der Interaktionsfläche (205) der Haltevorrichtung nach einem der Ansprüche 1 bis 11 fixiert ist, sodass sie parallel zur Ebene der Interaktionsfläche (302) ist.

## Revendications

1. Mâchoire pour maintenir un substrat ou une électrode maître dans un procédé de réplication électrochimique de motifs (ECPR) ladite mâchoire possédant une extrémité proximale et une extrémité distale, ladite mâchoire comprenant :
une surface d'interaction (205) pour maintenir le substrat ou l'électrode maître en position dans un premier plan ;
un moyen de maintien pour maintenir le substrat ou l'électrode maître contre ladite surface d'interaction (205) ;
des dents de nivellement (210) disposées en direction latérale et en direction circonférentielle par rapport à ladite surface d'interaction et s'étendant en direction distale au-delà de la surface d'interaction (205), les extrémités distales pointues desdites dents de nivellement (210) définissant un second plan ;
dans laquelle ledit second plan est parallèle au premier plan et est disposé en position distale par rapport au premier plan.

2. Mâchoire selon la revendication 1, dans laquelle les dents de nivellement (210) sont distribuées de manière égale autour de la surface d'interaction (205).

3. Mâchoire selon la revendication 1 ou 2, dans laquelle les dents de nivellement (210) sont distribuées en direction circonférentielle par rapport à la surface d'interaction en étant espacées de 120 degrés, calculé à partir d'un axe central de la mâchoire.

4. Mâchoire selon l'une quelconque des revendications précédentes, dans laquelle le nombre de dents de nivellement (210) est égal à au moins trois.

5. Mâchoire selon l'une quelconque des revendications précédentes, dans laquelle lesdites dents de nivellement (210) comprennent des bases de dents (212), respectivement, lesdites bases de dents (212) étant disposées dans le premier plan, et des éléments d'écartement (211) s'étendant en direction distale à partir desdites bases de dents (212) d'une manière telle que les extrémités distales pointues des dents de nivellement représentent les extrémités distales pointues des éléments d'écartement (211).

6. Mâchoire selon la revendication 5, dans laquelle les éléments d'écartement (211) sont insérés dans des trous (213) dans les bases des dents (212).

7. Mâchoire selon la revendication 5 ou 6, dans laquelle les éléments d'écartement sont magnétiques.

8. Mâchoire selon l'une quelconque des revendications précédentes, dans laquelle l'extrémité proximale de la mâchoire comprend une tête semi-sphérique (201), ladite tête semi-sphérique (201) étant disposée dans une cavité (202) dans une pièce formant chambre (203), ladite pièce formant chambre (203) comprenant une surface semi-sphérique concave (204) possédant un premier rayon (r1) correspondant au rayon de la tête semi-sphérique (201) d'une manière telle que la tête semi-sphérique (201) peut effectuer des rotations dans ladite surface concave (204) à la manière d'une rotule dans un joint, pour ainsi procurer une entrée pour les gaz dans la dite cavité (202).

9. Mâchoire selon la revendication 8, dans laquelle la tête semi-sphérique (201) est montée sur ressort contre la pièce formant chambre (203).

10. Mâchoire selon la revendication 9, dans laquelle la tête semi-sphérique (201) est montée sur ressort et des portions de la surface sont mises en état de précontrainte avec du vide en direction de la pièce formant chambre (203).

11. Mâchoire selon la revendication 8 ou 10, comprenant une seconde surface segmentaire-sphérique convexe (208) qui entre en interaction avec une surface segmentaire-sphérique concave (209) sur la pièce formant chambre (203), lesdites surfaces segmentaires-sphériques possédant un second rayon (r2).

12. Mâchoire selon l'une quelconque des revendications 8 à 11, dans laquelle le premier rayon (r1) et le second rayon (r2) possèdent le même centre de rotation disposé en un point central (207) sur la surface d'interaction (205).

13. Assemblage de mâchoires comprenant une mâchoire selon l'une quelconque des revendications 1 à 12, et une mâchoire opposée, ladite mâchoire opposée comprenant une surface d'interaction (302) pour maintenir le substrat ou l'électrode maître en position dans un troisième plan ; un moyen de maintien pour maintenir le substrat ou l'électrode maître contre ladite surface d'interaction (302) ; une zone de nivellement rigide (301) en direction latérale et en direction circonférentielle par rapport à ladite surface d'interaction (302), ladite zone de nivellement (301) correspondant en position latérale à la position latérale des dents de nivellement (210), ladite zone de nivellement (301) et ladite surface d'interaction (302) étant parallèles.

14. Procédé de nivellement d'un assemblage de mâchoires selon la revendication 13, comprenant le fait de :
amener la mâchoire selon l'une quelconque des revendications 1 à 11 et la mâchoire opposée en contact, d'une manière telle que les dents de nivellement (210) vont s'appuyer sur la zone de nivellement (301);
verrouiller la mâchoire selon l'une quelconque des revendications 1 à 11 d'une manière telle que le plan de la surface d'interaction (205) de la mâchoire selon l'une quelconque des revendications 1 à 11 est fixé pour être parallèle au plan de la surface d'interaction (302).
